# EUROPÄISCHE PATENTSCHRIFT

(11) **EP 3 093 267 B1**
(45) Veröffentlichungstag und Bekanntmachung des Hinweises auf die Patenterteilung: **07.08.2019**
(21) Anmeldenummer: 15167271.4
(22) Anmeldetag: 12.05.2015
(51) Int. Cl.: B81B 7/00

(54) **ELEKTRONISCHES HOCHFREQUENZ BAUELEMENT**
ELECTRONIC HIGH FREQUENCY COMPONENT
COMPOSANT ÉLECTRONIQUE HAUTE FRÉQUENCE

(43) Veröffentlichungstag der Anmeldung: 16.11.2016
(73) Patentinhaber: Airbus Defence and Space GmbH, 85521 Ottobrunn (DE)
(72) Erfinder: Schönlinner, Bernhard, 81547 München (DE); Prechtel, Ulrich, 81739 München (DE)
(74) Vertreter: Isarpatent

(56) Entgegenhaltungen:
- EP-A1- 0 637 871
- US-A1- 2003 030 516
- US-B1- 6 384 353

## Beschreibung

Die vorliegende Anmeldung betrifft ein elektronisches Bauelement, insbesondere ein Bauelement für die Anwendung im Hochfrequenzbereich, das bevorzugt einen oder mehrere Kleinstapparate hermetisch gegenüber einer Außenumgebung abkapseln kann, wobei gleichzeitig ein möglichst ungestörtes Einführen und Ausführen von Hochfrequenzsignalen in das Innere des Bauelementes ermöglicht wird. Die Kleinstapparate sind bevorzugt Mikroelektromechanische Systeme (MEMS), Mikrooptoelektromechanische Systeme (MOEMS) oder dgl.

Bekannte elektronische Bauelemente weisen regelmäßig ein nach außen hermetisch gekapseltes Gehäuse auf, um eine zuverlässige Funktion des darin platzierten MEMS zu gewährleisten. Das Gehäuse wird meist aus zwei Teilen hergestellt, die aus Halbleiterwafern bestehen oder aus diesen herausgeschnitten wurden. An den Stellen, an denen ein Hohlraum für die Platzierung des MEMS benötigt wird, wird beispielsweise mittels bekannter Ätzverfahren eine Ausnehmung in eines der Teile oder in beide Teile des Gehäuses eingebracht. Die beiden Gehäuseteile können anschließend mittels bekannter Verfahren fest miteinander verbunden werden. Min und Rebeiz diskutieren solche Verbindungsverfahren (Byung-Wook Min and Gabriel M. Rebeiz in IEEE Transactions on Microwave Theory and Techniques, Vol. 54, No. 2, Feb. 2006, pages 710ff.: "A Low-Loss Silicon-on-Silicon DC-110-GHz-Resonance-Free Package").

Eine Möglichkeit des Verbindens besteht in der Verwendung von sogenannten "Glass frit"-Bondverfahren, die jedoch bei hohen Temperaturen durchgeführt werden müssen, was zu thermisch induzierten Spannungen und dgl. im Bauelement führen kann. Bevorzugt wird deshalb häufig auf metallische Bondrahmen gesetzt. Diese werden beispielsweise umlaufend um den gewünschten Hohlraum angeordnet, um dann mittels Bondtechnik miteinander "verschweißt" zu werden. Dabei kann auf den Einsatz sehr hoher Temperaturen, wie beim "Glass frit"-Bonden notwendig, verzichtet werden. Auch können die metallischen Bondrahmen schmaler ausgeführt werden.

Zudem wird technisch gefordert, dass elektrische Hochfrequenzsignale in das Innere des Gehäuses geleitet werden können, wofür Signaldurchführungen notwendig sind. Im Falle von Hochfrequenzsignalen besteht das technische Problem, dass ein Übersprechen des Signals auf den metallischen Bondrahmen stattfindet und dadurch bei bestimmten Frequenzen die Signaldurchführung beeinträchtigt ist, d.h. Verluste entstehen. Dies gilt besonders, wenn die Signalleitung im Inneren des Gehäuses als eine Mikrostreifenleitung (MSL) ausgebildet ist.

Bekannte Bauelemente zeigen Konfigurationen bzw. Konzepte auf, mit denen die Signalbeeinträchtigungen aufgrund von parasitären Kopplungen zwischen dem metallischen Bondrahmen und den Durchführungen bzw. den Leitungen, die durch die Durchführung verlaufen, reduziert werden sollen. So beschreiben Margomenos und Katehi sowie Yu und Liao Konzepte, bei denen die Signalleitung innerhalb und außerhalb des Gehäuses als Koplanarleitung ausgeführt ist und die Leitungen über eine vertikale Durchführung durch drei parallele Durchkontaktierungen (throughsilicon vias; kurz: "TSVs") verbunden sind (Margomenos, A. und Katehi, L.P.B at 34th European Microwave Conference, Amsterdam, 2004, pages 645 ff.: "Ultra-wideband three dimensional transitions for on-wafer packages"; sowie Yu W. und Liao, X. at the International Conference on Electronic Packaging Technology & High Density Packaging, IEEE, 2009, pages 201 ff.: "Design and simulation of a package solution for millimeter wave MEMS switch").

Diese Konfigurationen erzeugen zwar bereits eine geringere Kopplung mit dem Bondrahmen, aber ein noch größerer Reduktionsbedarf wird bereits von Lim et. al. beschrieben (Lim, Y.Y. et al at Transducers 2011, Beijing, June 2011, pages 406 ff.: "A broadband 3D package for RF MEMS devices utilizing through silicon vias TSV"). Die weitere Reduktion von unerwünschten Signalbeeinträchtigungen soll nach Lim et al. durch zusätzliche, im Hohlraum freistehende TSVs herbeigeführt werden.

Auch bei dieser Konfiguration treten jedoch weiterhin parasitäre Kopplungen auf, so dass weiterhin Bedarf für eine Optimierung der Signalbeeinträchtigung besteht.

Ferner verfolgen die oben genannten Min und Rebeiz eine andere Konfiguration, bei der eine laterale Durchführung mit einer dünnen Isolierschicht zum Bondrahmen versehen ist. Die negativen Auswirkungen der dadurch herbeigeführten relativ starken Kopplung werden unterbunden, indem die dünne Isolierschicht abseits der Signalleitung entfernt wird und der Bondrahmen und die Masse der Koplanarleitung verbunden werden. Diese Konfiguration ist jedoch im Hinblick auf die Herstellung des Bauelementes relativ aufwendig. Weiterhin ist ein Bauelement mit einer lateralen Durchführung nur mit großem Aufwand auf einer Leiterplatte integrierbar. So ist es für einen guten Signalübergang von der Leiterplatte auf das Bauelement notwendig, dass Taschen in die Leiterplatte eingebracht werden, die das Bauelement aufnehmen und die die Anschlusskontakte auf die gleiche Höhe wie die Anschlusskontakte auf der Leiterplatte bringen. Der elektrische Anschluss erfolgt in der Regel über Bonddrähte. Das Herstellen der Taschen in der Leiterplatte und der elektrische Anschluss mit Bonddrähten sind jedoch relativ aufwendige und damit auch teure Verfahren.

EP 0 637 871 A1 beschreibt einen Schaltungsbaustein mit akustischer Oberflächenwellenanordnung mit einem Mehrschichtsubstrat, das eine Abschirmmusterschicht, Eingangs-/Ausgangselektroden, Masseelektroden und Durchgangslöcher zum Verbinden der Elektroden aufweist. Das akustische Oberflächenwellenelement weist metallische Erhebungen auf, die mit einem leitenden Harz transferbeschichtet sind. Ferner ist ein metallischer Deckel vorgesehen, so dass das akustische Oberflächenwellenelement durch den metallischen Deckel in einem luftdichten Zustand versiegelt ist.

US 6 384 353 B1 beschreibt eine mikroelektromechanische Vorrichtung (MEMS). Ein MEMS-Bauelement ist auf einem Substrat angeordnet. Das Substrat weist leitend gefüllte Vias auf. Das MEMS-Bauelement ist elektrisch mit den leitend gefüllten Vias verbunden. Das MEMS-Bauelement wird von einem Schutzdeckel bedeckt. Eine elektrische Verbindung ist auf einer Bodenfläche des Substrats angeordnet, um elektrischer Signale an das MEMS-Bauelement zu leiten.

Es besteht Bedarf für ein elektronisches Bauelement zur Integration von Kleinstapparaten in einem Hohlraum des Bauelementes, wobei Hochfrequenzsignale in/aus das/dem Innere(n) des Bauelementes mittels Hochfrequenzsignalleitungen hinein- bzw. herausgeführt werden können, ohne dass die Signale durch parasitäre Kopplungen mit dem Bauelement oder Teilen davon beeinträchtigt werden. Zudem besteht Bedarf für ein Bauelement, das weniger aufwendig in der Herstellung ist.

Diese Aufgabe wird von dem hier beschriebenen elektronischen Bauelement gemäß Anspruch 1 gelöst. Bevorzugte Weiterentwicklungen werden von den abhängigen Ansprüchen beschrieben.

Gemäß der Erfindung wird hier ein elektronisches Hochfrequenz-Bauelement zur Aufnahme von Kleinstapparaten mit zumindest zwei Gehäusebauteilen beschrieben, die mittels eines metallischen Rahmens miteinander verbunden sind und einen Hohlraum einschließen. Der Hohlraum ist innerhalb des metallischen Rahmens angeordnet.

Das Hochfrequenz-Bauelement (kurz: Bauelement) weist zumindest eine Eingangs- und auch zumindest eine Ausgangssignalleitung auf. Die Eingangs- und Ausgangssignalleitung sind jeweils mit einer Signalleitungsdurchkontaktierung verbunden. Diese beiden Signalleitungsdurchkontaktierungen können (innerhalb des Hohlraums oder besonders bevorzugt innerhalb des Bondrahmens) beabstandet zueinander angeordnet sein und zumindest mittels einer inneren Signalleitung miteinander verbunden sein. Die genannte Verbindung der beiden Signalleitungsdurchkontaktierungen schließt nicht aus, dass, für den Fall, dass die innere Signalleitung mit einem MEMS-Schalter oder dgl. verbunden sein sollte, die innere Leitung in bestimmten Schaltungszuständen des Schalters elektrisch unterbrochen ist.

Ferner weist das hier beschriebene Bauelement Kuzschluss-Durchkontaktierungen auf, die den metallischen Rahmen mit einer metallischen Massefläche an einem der Gehäusebauteile des Bauelementes elektrisch verbindet.

Bevorzugt kann eine Kurzschluss-Durchkontaktierung innerhalb des metallischen Rahmens und/oder des Hohlraumes angeordnet sein. Die Kurzschluss-Durchkontaktierung kann alternativ oder zusätzlich auch außerhalb des Hohlraums angeordnet sein und damit nicht innerhalb des metallischen Rahmens. So kann optional auch eine Kurzschluss-Durchkontaktierung außerhalb des metallischen Rahmens anordenbar sein. Ferner kann optional eine elektrische Verbindung in Form einer Leitung hergestellt sein, die an der Chipaußenseite entlangläuft und so den metallischen Rahmen mit einer (großen) Masse(-fläche) an der Außenseite verbindet. Diese elektrische Leitung kann beispielsweise mittels einer Metallisierung einer Seitenwand eines Gehäusebauteils hergestellt werden.

Der metallische Rahmen kann bevorzugt ein metallischer Bondrahmen sein, der bevorzugt einen rechteckigen, quadratischen oder runden Querschnitt aufweist. Der Vorteil des metallischen Rahmens wurde bereits oben dargestellt; u.a. bedarf es keiner hohen Temperaturen zum Fügen der Gehäusebauteile, wie z.B. bei "Glass frit"-Bondverfahren. Der metallische Rahmen kann bevorzugt zwischen den bevorzugt zwei Gehäusebauteilen vorgesehen sein (mehr als zwei Gehäusebauteile sind auch möglich). Der Hohlraum kann beispielsweise mittels bekannter Ätzverfahren in zumindest eines der Gehäusebauteile eingebracht worden sein. Bevorzugt können die Gehäusebauteile Halbleiterwafer oder Teile davon sein; besonders bevorzugt werden Siliziumwafer, insbesondere aus hochresistivem Silizium. Alternativ können die Gehäusebauteile auch aus Glas, Quarz oder einer Keramik bestehen.

Die Durchkontaktierung(en) ist/sind bevorzugt elektrisch leitend und besonders bevorzugt aus Metall.

Der zumindest eine Kleinstapparat kann ein mikroelektromechanisches oder mikrooptoelektromechanisches System (MEMS/MOEMS) oder ein entsprechendes Nanosystem sein. Ein Beispiel eines MEMS wäre ein Schalter in einer Hochfrequenzsignalleitung. Es ist anzumerken, dass der Hohlraum gemäß einer besonders bevorzugten Alternative nur für die Aufnahme des MEMS vorgesehen sein kann und insbesondere dann wesentlich kleiner als der Bondrahmen gestaltet sein kann.

Das hier beschriebene Bauelement weist somit den technischen Vorteil auf, dass die Herstellung relativ wenig Aufwand verlangt, u.a. deshalb weil keine Signaldurchführungsisolierungen hergestellt werden müssen, die dann an vorgegebenen Stellen auch wieder aufwendig entfernt werden müssten. Ferner kann das Bauelement kostengünstig auf einer Leiterplatte integriert werden. Darüber hinaus wird der technische Vorteil erzielt, dass der Hohlraum aufgrund der fest miteinander verbundenen Gehäusebauteile und des metallischen Rahmens gegen ein Eindringen von Schmutz, Feuchtigkeit und dgl. abgeschirmt ist und gleichzeitig eine Durchführung eines Hochfrequenzsignals in das mittels des metallischen Bondrahmens hermetische Gehäuse möglich ist, ohne dass das Signal durch eine parasitäre Verkopplung von Signalleitung und Bondrahmen beeinträchtig werden würde.

Die technisch vorteilhafte Unterdrückung/Minimierung einer Signalbeeinträchtigung beim Eintritt und/oder Austritt des Signals wird hier bevorzugt wie folgt erreicht: eine elektromagnetische Welle oder ein Teil davon, die das Signal überträgt, kann beim Durchlaufen der Eingangs- bzw. Ausgangsleitung in den metallischen Rahmen einkoppeln. Mit anderen Worten kann ein Teil der elektrischen Leistung bzw. des Signals in den metallischen Rahmen überspringen und sich dort ausbreiten. Der dadurch entstehende Signalverlust wird hier u.a. dadurch unterbunden bzw. reduziert, dass der elektrische Kurzschluss zwischen dem Gehäusebauteil bzw. einer Masse bzw. Metallfläche, die auf dem Gehäusebauteil angeordnet ist, auf dem die Eingangs- bzw. Ausgangsleitung angeordnet ist, und dem metallischen Rahmen, den die Kurzschluss-Durchkontaktierung erzeugt, zu einer Reflektion der eingekoppelten elektromagnetische Welle führt. Die Reflektion führt dann zu einer gegenseitigen Auslöschung mit der eingekoppelten elektromagnetischen Welle. Anders kann der hier genutzte technische Effekt auch so beschrieben werden, dass die Länge des Resonators, hier der metallische Rahmen, halbiert bzw. zumindest verkürzt wird (je nach Platzierung der Kurzschluss-Durchkontaktierung), so dass sich die Resonanzfrequenz verdoppelt bzw. entsprechend erhöht und diese damit nicht mehr im Signalspektrum liegt.

Erfindungsgemäß ist jeweils seitlich zu der Eingangs- und Ausgangssignalleitung zumindest eine Kurzschluss-Durchkontaktierung angeordnet. Die Kurzschluss-Durchkontaktierungen können besonders bevorzugt möglichst nah an einer Seite der Eingangs- bzw. Ausgangssignalleitung platziert sein. Erfindungsgemäß ist auf jeder Seite der Eingangs- und Ausgangssignalleitung jeweils eine Kurzschluss-Durchkontaktierung angeordnet. Die seitliche Anordnung hat gezeigt, dass besonders effektiv eine destruktive Reflektion im metallischen Rahmen erzeugt werden kann, so dass die Minimierung der Signalstörungen besonders effektiv ist.

Ganz besonders bevorzugt können beispielsweise bei jeweils einer Eingangs- und Ausgangssignalleitung sowie jeweils zwei dazu seitlich angeordneten Kurzschluss-Durchkontaktierungen (d.h. vier) diese vier Kurzschluss-Durchkontaktierungen innerhalb des metallischen Rahmens platziert werden, um eine besonders wirksame Reduktion von Signalstörungen zu erzielen.

Besonders bevorzugte Positionen für die Anordnung einer Kurzschluss-Durchkontaktierung finden sich an einer Seitenkantenmitte und/oder Seitenkantenecke des Bauelementes bzw. des metallischen Rahmens, insbesondere wenn Grundschwingungen des Resonators beeinflusst werden sollen..

Gemäß einem alternativen oder zusätzlichen Aspekt kann eine (oder auch mehrere) Kurzschluss-Durchkontaktierung mittels einer metallisierten Seitenwand von zumindest einem der beiden Gehäusebauteile ausgeführt sein. Damit ist insbesondere gemeint, dass mittels Metallisierung eines Teils oder gesamten Seitenwand eine Durchkontaktierung hergestellt werden kann, wobei die metallisierte Seitenwand bzw. deren Metallschicht den elektrischen Kurzschluss zwischen Rahmen und Masse herstellt. Die Seitenwand kann besonders bevorzugt eine Außenwand des Gehäusebauteiles sein und muss nicht vollständig metallisiert sein. Mittels der Metallisierung wird wie bei den bereits oben beschriebenen Kurzschluss-Durchkontaktierungen ein elektrischer Kurzschluss zwischen dem metallischen Rahmen und der Masse der Eingangs- und/oder Ausgangssignalleitung hergestellt, der Signalstörungen wie bereits erläutert erheblich reduziert oder sogar verhindern kann. Diese Ausführung hat dabei den technischen Vorteil, dass eine bauraumoptimierte Gestaltung des Bauelementes ermöglicht wird.

Gemäß weiterer bevorzugter Aspekte kann die innere Signalleitung eine Koplanarleitung oder ganz besonders bevorzugt eine Mikrostreifenleitung sein, die einen Kleinstapparat elektrisch mit der Eingangs- und Ausgangssignalleitung verbinden kann. Die Eingangs- und Ausgangsleitungen können bevorzugt Koplanarleitungen sein. Die Kurzschluss-Durchkontaktierung(en) können bevorzugt eine elektrische Masse der der Eingangs- und Ausgangsleitungen mit dem metallischen Rahmen elektrisch verbinden. Die elektrische Masse ist Teil eines der Gehäusebauteile oder darauf angeordnet. Die Verwendung von Mikrostreifenleitungen (im Vergleich zu Koplanarleitungen) in Kombination mit Siliziumgehäusebauteilen hat den Vorteil, dass keine oder nur geringe Verluste aufgrund von leitfähigen Grenzschichten zwischen Silizium und Sililziumoxid entstehen.

Besonders bevorzugt können die Durchkontaktierungen gemäß einem weiteren Aspekt vertikal zum Hohlraum angeordnet sein, d.h. vertikal zu den parallel zueinander angeordneten Gehäusebauteilen stehen. Somit wird eine vertikale Durchführung eines Hochfrequenzsignals in ein mittels eines metallischen Bondrahmens hermetisches Gehäuse möglich, ohne dass das Signal durch die Verkopplung von Signalleitung und Bondrahmen beeinträchtig wird. Es ist dadurch eine breitbandige Signaldurchführung möglich. Die vertikale Durchführung hat ferner den technischen Vorteil, dass keine weiteren Isolationen der Signalleitungen aufgebracht werden müssen, wie dies bei z.B. lateraler Durchführung notwendig wäre und was die Herstellung komplexer werden lässt. Auch wird durch die vertikale Anordnung die Integration des Bauelementes auf einer Leiterplatte erleichtert. So kann das Bauelement mit den Anschlusskontakten auf einer der beiden großen Außenflächen wie ein reguläres SMD-Bauteil (surface mount device Bauteil) mit Hilfe eines Lötverfahrens sehr kostengünstig und mit relativ wenig Aufwand auf der Leiterplatte integriert werden.

Gemäß einem weiteren Aspekt können eine oder mehrere Durchführung(en), in der die Signalleitungsdurchkontaktierung angeordnet sein kann, innerhalb des metallischen Rahmens angeordnet sein. Ganz besonders bevorzugt kann die Durchführung bzw. Signalleitungsdurchkontaktierung an einer Position angeordnet sein, an der ein möglichst großer (oder ganz besonders bevorzugt maximaler) Unterschied zwischen dem Wellenwiderstand der Eingangs- oder Ausgangssignalleitung und dem des metallischen Rahmens vorliegt. Diese Positionierung der Durchführung(en) ermöglicht eine weitere erhebliche Reduktion der Signalstörung, da die Einkopplung der Signalwelle in den metallischen Rahmen zunächst behindert wird und zusätzlich die Auslöschung einer möglicherweise dennoch eingekoppelten Welle mittels der Kurzschluss-Durchkontaktierungen ausgelöscht werden kann.

Gemäß einem weiteren bevorzugten Aspekt kann das Bauelement bzw. können die Gehäusebauteile eine rechteckige, runde oder quadratische Form aufweisen, um eine möglichst handliche Form zu erzielen. Der metallische Rahmen kann bevorzugt an einer Außenkante des Bauelementes bzw. der beiden Gehäusebauteile angeordnet sein; besonders bevorzugt bündig zu dieser. Ferner kann der metallische Rahmen eine Breite von wenigen Mikrometern bis hin zu mehreren Zehnmikrometern aufweisen, um eine möglichst sichere Abdichtung bzw. Einkapselung des Hohlraums zu erzielen. Beispielhaft werden Werte zwischen 50 µm und 300 µm bevorzugt.

Ferner können die Signalleitungsdurchkontaktierungen elektrisch miteinander verbundener Signaleingangs- und Ausgangsleitungen gegenüber liegend angeordnet sein (über den Hohlraum hinweggesehen), so dass die Leitung(en) zwischen den Signalleitungsdurchkontaktierungen möglichst linear/gerade ausgeführt sein können.

Gemäß einem weiteren besonders bevorzugten Aspekt können die Eingangs- und Ausgangssignalleitungen jeweils auf dem gleichen Gehäusebauteil angeordnet sein, wie die innere Signalleitung. Alternativ können die Eingangs- und Ausgangssignalleitungen auch auf einem ersten Gehäusebauteil angeordnet sein, und die innere Signalleitung auf dem zweiten Gehäusebauteil. Weiter bevorzugt können die Signalleitungsdurchkontaktierungen die innere Signalleitung jeweils mit der Eingangs- und Ausgangssignalleitung elektrisch (senkrecht) verbinden, so dass eine vertikale Durchführung des Hochfrequenzsignals durch die Signalleitungsdurchkontaktierungen ermöglicht wird.

Zusammengefasst wird hier ein elektronisches Bauelement für die Handhabung von Hochfrequenzsignalen vorgestellt, das weniger Herstellungsaufwand erfordert und Signalbeeinträchtigungen beim Einleiten und Ausleiten eines Hochfrequenzsignales in den Hohlraum des Bauelementes bestmöglich reduziert. Weiterhin lässt sich das Bauelement insbesondere aufgrund der Anordnung der Signalleitungssdurchkontaktierungen leichter auf einer Leiterplatte integrieren.

Das hier dargelegte elektronische Bauelement wird im Folgenden exemplarisch mit Bezug auf die beigefügten, schematischen Zeichnungen beschrieben. Es zeigen
- Fig. 1a: eine Rasterelektronenmikroskopaufnahme eines bekannten elektronischen Hochfrequenz-Bauelementes,
- Fig. 1b: eine detailreduzierte schematische Zeichnung eines Hochfrequenz-Bauelementes,
- Fig. 2: eine detailreduzierte schematische Zeichnung eines Hochfrequenz-Bauelementes,
- Fig. 3: eine detailreduzierte schematische Zeichnung eines Hochfrequenz-Bauelementes,
- Fig. 4: eine detailreduzierte schematische Zeichnung eines hier beschriebenen Hochfrequenz-Bauelementes,
- Fig. 5: eine detailreduzierte schematische Schnittansicht des hier beschriebenen Hochfrequenz-Bauelementes,
- Fig. 6: eine Darstellung von Messergebnissen einer Transmission eines bekannten Hochfrequenz-Bauelementes mit Einbrüchen aufgrund von unerwünschten Kopplungseffekten, und
- Fig. 7: eine Darstellung von Messergebnissen einer Transmission eines bekannten Hochfrequenz-Bauelementes mit Einbrüchen aufgrund von unerwünschten Kopplungseffekten (s. auch Fig. 6) und Simulationsergebnissen einer Transmission eines Hochfrequenz- Bauelementes ohne Einbrüchen aufgrund von unerwünschten Kopplungseffekten.

Im Folgenden werden verschiedene Beispiele detailliert und unter Bezugnahme auf die Figuren beschrieben. Gleiche bzw. ähnliche Elemente in den Figuren werden hierbei mit gleichen Bezugszeichen bezeichnet. Die vorliegende Vorrichtung ist jedoch nicht auf die beschriebenen Kombinationen von Merkmalen begrenzt. Vielmehr sollen auch weitere Modifikationen und Kombinationen von Merkmalen verschiedener Beispiele im Rahmen des Schutzumfangs der unabhängigen Ansprüche umfasst sein.

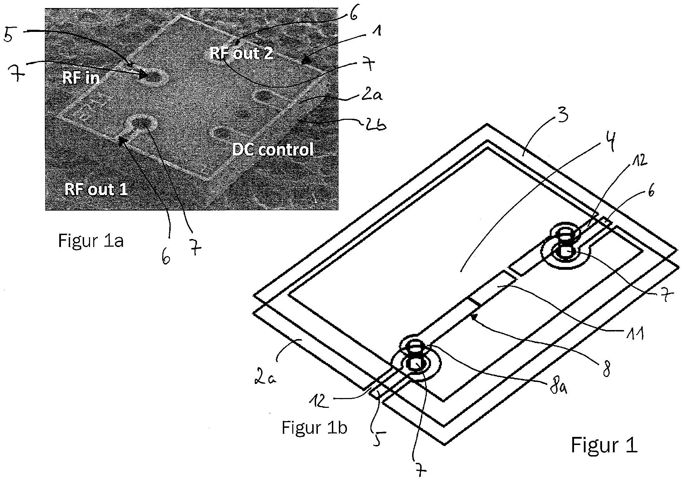

Figur 1a zeigt eine Rasterelektronenmikroskopaufnahme eines bekannten Hochfrequenz-Bauelementes 1, das vertikale Hochfrequenzdurchführungen in einen Hohlraum 4 des Bauelementes 1 aufweist. Konkret ist aus der Figur 1a ersichtlich, dass zwei Siliziumwafergehäusebauteile 2a und 2b bündig übereinander gelegt und fixiert sind. Auf dem oberen Gehäusebauteil 2a sind Koplanarleitungen als Eingangs- und Ausgangssignalleitungen 5, 6 aufgebracht, die mit vertikalen Durchkontaktierungen, genauer Signalleitungsdurchkontaktierungen 7, verbunden sind. In der Figur 1a weist das Bauelement 1 zwei Ausgänge auf, die mit "RF out 1/2" markiert sind und einen Eingang, der mit "RF in" gekennzeichnet ist. Das Bauelement 1 bzw. dessen Gehäusebauteile 2a, 2b weisen eine übliche rechteckige Form auf und besitzen an einer Seitenkante ferner Kontakte für Steueranschlüsse, wovon einer mit "DC control" gekennzeichnet ist.

Gefügt sind die beiden Gehäusebauteile 2a, 2b mittels eines metallischen (Bond-)Rahmens 3, der in Fig. 1a nicht sichtbar ist, da er zwischen den beiden Gehäusebauteile 2a, 2b angeordnet ist und eine Höhe von nur einigen Nano- oder maximal Mikrometern aufweist.

Fig. 1b zeigt eine vereinfachte schematische Zeichnung eines Beispiels eines hier beschriebenen Bauelementes 1 (in Fig. 1b der Einfachheit halber noch ohne Kurzschluss-Durchkontaktierungen), in der der metallische Rahmen 3 von zwei parallel zueinander im Rechteck verlaufenden Linien angezeigt wird. Der Körper des Bauelementes 1 ist gegenüber der Darstellung des bekannten Bauelementes gemäß Fig. 1a umgedreht worden, so dass das erste Gehäusebauteil 2a nun nach unten zeigt und das zweite Gehäusebauteil 2b nach oben, wobei dieses nicht weiter gezeigt ist. Das erste Gehäusebauteil 2a ist vereinfacht nur als rechteckige Fläche dargestellt, die Aufnahmebereiche 12 für die Leitungsführung der Eingangssignalleitung 5 und der Ausgangssignalleitung 6 aufweist. Diese Leitungen 5, 6 laufen jeweils auf eine vertikale Signalleitungsdurchkontaktierung 7 zu, die innerhalb des metallischen Rahmens 3 angeordnet sind, wie Fig. 1b zeigt.

Fig. 1b zeigt dann weiterhin, dass in vertikaler Richtung entlang der Längsachse der Signalleitungsdurchkontaktierung 7, die auch als TSV oder through silicon via bezeichnet wird, am anderen Ende ein elektrischer Kontakt mit einer weiteren inneren Leitung 8 bzw. deren Kontaktierungsstelle 8a hergestellt ist. Die Signalleitungsdurchkontaktierung 7 oder TSV ist üblicherweise aus Metall gefertigt und innerhalb einer Durchführung eingebracht. Die Anordnung der Ausgangs- und Eingangssignalleitungen 5, 6 sowie der Signalleitungsdurchkontaktierungen 7 ist gemäß dem Beispiel der Figur 1b bereits abweichend von dem bekannten Bauelement 1 gemäß Figur 1a gezeigt. Dies hat den technischen Hintergrund, dass die Signalleitungsdurchkontaktierungen 7 bzw. dessen Durchführungen 10 für dieses Ausführungsbeispiel beispielhaft bereits so angeordnet wurden, dass Wellenwiderstände der Ausgangs- und Eingangssignalleitungen 5, 6 und des metallischen Rahmens 3 an dieser möglichst ungleich sind. Spezifischer wurde für die Figur 1b eine Positionierung bei ca. ¾ der Seitenkantenlänge des Bauelementes ausgewählt, die im Hinblick auf eine erste Oberschwingung des Resonators im metallischen Rahmen 3 eine bevorzugte Position ist, um ein Einkoppeln in den metallischen Rahmen 3 zu unterdrücken. Die gezeigte Positionierung soll jedoch als rein bespielhaft und nicht einschränkend angesehen werden, da eine konkrete Positionierung gemäß dem hier beschriebenen Bauelement danach ausgewählt werden soll, welche Schwingungen (z. B. Grundschwingung, erste Oberschwingung, etc.) beeinflusst werden sollen und wo im Hinblick auf diese ein Unterschied im Wellenwiderstand zwischen dem metallischem Rahmen 3 und der der Ausgangs- und Eingangssignalleitungen 5, 6 möglichst groß ist. Dieser Punkt wird nachfolgend noch genauer betrachtet werden.

Zudem zeigt die Figur 1b eine innere Leitung oder Signalleitung 8, die die Ausgangs- und Eingangssignalleitungen 5, 6 mit einem Kleinstapparat 11, z.B. einem MEMS, verbindet.

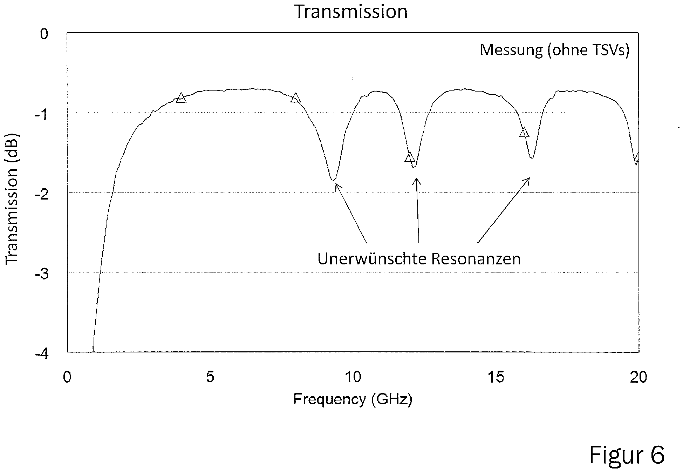

Ein technischer Nachteil des im Zusammenhang mit Figur 1a beschriebenen Bauelementes 1 ist insbesondere, dass Signale, die in den Hohlraum 4 des Bauelementes 1 eingeleitet werden, in den metallischen Rahmen 3, der eine geschlossene Konfiguration aufweist, überspringen können und somit zu einer Signalbeeinträchtigung führen können. Mit anderen Worten koppelt das Hochfrequenzsignal mit dem metallischen Rahmen 3, so dass unerwünschte Resonanzen entstehen, die sich als Einbrüche in der Transmission äußern. Diese zeigt Figur 6.

Im Detail zeigt Figur 6 auf der Hochachse die dB-Zahl der Transmission, d.h. die übertragene Signalstärke. Diese ist über ein Frequenzspektrum von 0 - 20 GHz gezeigt und zwar für eine Messung (dreieckige Markierungen) an einem bekannten Bauelement, das insbesondere keine Kurzschluss-Durchkontaktierungen aufweist. Das simulierte Bauteilverhalten und insbesondere die Resonanzeffekte, d.h. Signaleinbrüche, werden in Figur 6 deutlich sichtbar und sind für einige beispielhaft mittels Pfeilen gesondert markiert.

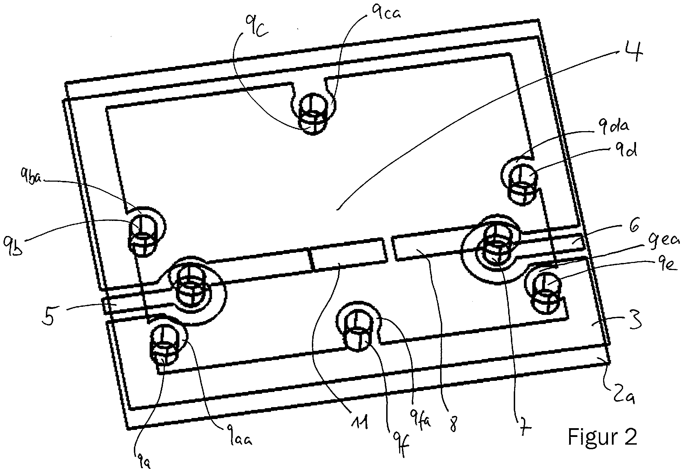

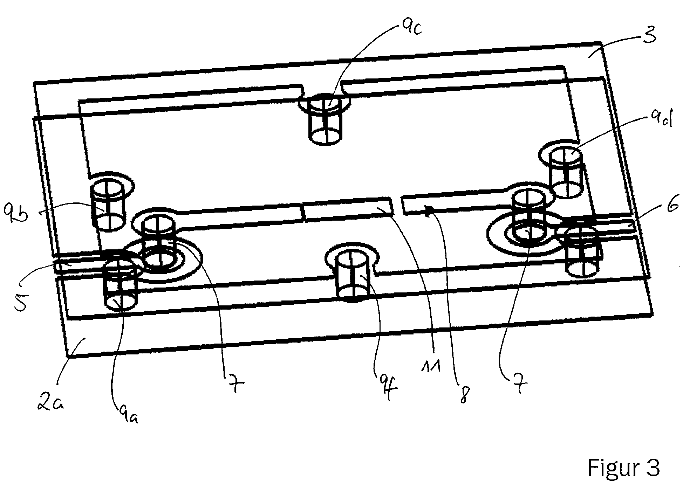

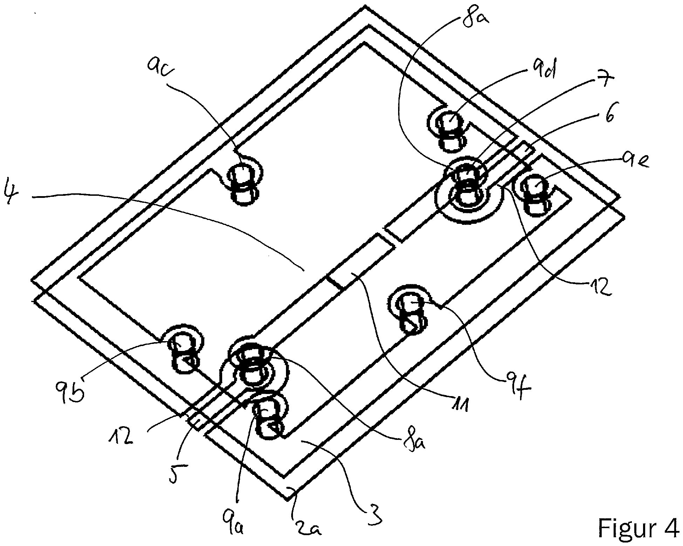

Die oben diskutierten Einbrüche des Signals sind technisch unerwünscht und sollen deshalb möglichst vollständig reduziert werden. Dies wird mit der hier beschriebenen Vorrichtung bzw. dem elektronischen Hochfrequenz-Bauelement 1 erreicht, das in einer besonders bevorzugten Ausführung in den Figuren 2 - 5 dargestellt ist. Die Darstellung ist dabei die gleiche wie die der Figur 1b, d.h. im Wesentlichen ist das Gehäusebauteil 2a nur schematisch mittels einer rechteckigen Fläche eingezeichnet und das Gehäusebauteil 2b ist entfernt bzw. es sind nur die darauf angeordneten Teile gezeigt, wie z.B. die Kontaktierungsfläche 8a der inneren Signalleitung 8. Der metallische Rahmen 3 wird als durchgehendes Rechteck von zwei parallel zueinander verlaufenden Linien gezeigt. Die Durchkontaktierungen 7, 9 sind als dreidimensionale Objekte wiedergegeben.

Bevor die Ausführungsformen gemäß der Figuren 2 - 5 weiter erläutert werden, soll zunächst darauf hingewiesen werden, dass bereits ein technischer Unterschied zwischen den Bauelementen 1 der Figuren 1b und 2 - 5 und dem bekannten Bauelement 1 gemäß Figur 1a vorhanden ist. So sind die Durchführungen 10 für die Durchkontaktierungen der Figuren 1b und 2 - 5 so angeordnet, dass Wellenwiderstände der Eingangs- und Ausgangssignalleitungen 5, 6 und des Rahmens 3 nicht zueinander passen, um eine Einkopplung in den Rahmen 3 zu vermeiden. Rein beispielhaft wurde für die Figuren eine Positionierung bei ca. ¾ der Seitenkantenlänge des Bauelementes 1 ausgewählt, die im Hinblick auf die erste Oberschwingung des Resonators des metallischen Rahmens 3 eine bevorzugte Position ist. Andere Beispiele für die Positionierung, z.B. im Hinblick auf die Grundschwingungen, umfassen die Platzierung in einer Ecke oder Seitenkantenmitte. Der technische Hintergrund dazu ist wie folgt: Ein typischer Resonator ist an seinen Enden entweder von einem Kurzschluss oder einer offenen Leitung begrenzt. Beide Varianten verursachen eine komplette Reflexion der geführten elektromagnetischen Welle, sodass die Welle im Resonator fortlaufend "hin- und hergestoßen" wird. Der Kurzschluss ist ein Ort mit sehr geringem Wellenwiderstand bzw. 0 Ohm, die offene Leitung hat einen sehr hohen Wellenwiderstand. Zwischen den beiden Enden eines Resonators treten alle möglichen Wellenwiderstände auf und es gibt mindestens einen Ort mit sehr hohem und mindestens einen Ort mit sehr niedrigem Wellenwiderstand. Da die Mikrostreifenleitung (oder Koplanarleitung) im Bauelement 1 bzw. Chip einen Wellenwiderstand von beispielsweise 50 Ohm aufweist, sind Orte auf dem metallischen Rahmen 3, an denen nur wenig Signal überkoppelt, Orte mit entweder sehr geringem oder sehr hohem Wellenwiderstand, aber nicht mit einem Wellenwiderstand von nahe 50 Ohm.

In Fig. 1b kann man die Ecken näherungsweise als offene Leitung betrachten, sodass sich an den kürzeren Seiten des metallischen Rahmens 3 zwischen den Ecken ein Resonator ausbildet, der an den Ecken einen sehr hohen Wellenwiderstand aufweist und in der Mitte einen sehr niedrigen Wellenwiderstand. Bevorzugte Orte für die Durchführung wären in Fig. 1b folglich die Mitte zwischen zwei Ecken oder sehr nahe an den Ecken, insbesondere wenn man die Grundschwingungen des Resonators adressiert.

Da ein Resonator nicht nur eine "Grundschwingung" aufweist, sondern auch Schwingungen höherer Ordnung (oder Oberwellen/-schwingungen), sind die bevorzugten Positionierungen (d.h. die Stellen, an denen die Wellenwiderstände möglichst weit auseinander liegen) für die Modifikation der Schwingungen höherer Ordnung ggf. abweichend von den Seitenkantenmitten oder Ecken gelegen. So zeigen Fig. 1b und die weiteren Figuren 2 - 5 beispielsweise eine bevorzugte Positionierung bei ¾ der Seitenkantenlänge, die besonders günstig im Hinblick auf die erste Oberschwingung ist.

Weiterhin ist zu beachten, dass der beschriebene Resonator aus Fig. 1b durch zusätzliche Kurzschluss-Durchkontaktierungen verändert werden kann, z.B. 9c und 9f in Figur 2, sodass der dominante Resonator durch diese beiden Durchkontaktierungen ebenfalls bereits begrenzt werden kann.

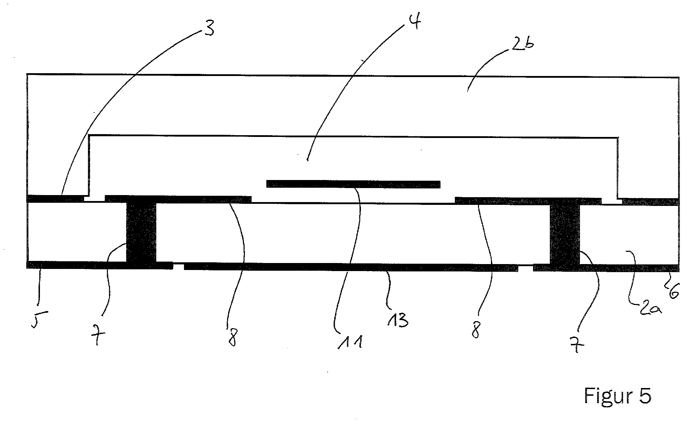

Ein weiterer technischer Unterschied zu der besonders bevorzugten Ausführung gemäß den Figuren 2 - 5 liegt ferner darin, dass diese bevorzugten Ausführungsbeispiele weitere Durchkontaktierungen 7, 9 aufweisen, die jedoch nicht der Signalleitung im eigentlichen Sinne dienen, sondern als Kurzschluss-Durchkontaktierungen 9a-f vorgesehen sind. Diese stellen einen elektrischen Kurzschluss zwischen dem metallischen Rahmen 3 und der Masse der Eingangs- bzw. Ausgangssignalleitung 5, 6 her. Die Masse ist in der Figur 1b nicht dargestellt (jedoch in Figur 5). Diese liegt auf (bzw. ist darin integriert) dem Gehäusebauteil 2a, das die Eingangs- und Ausgangssignalleitung 5, 6 trägt. Der elektrische Kurzschluss hat den vorteilhaften technischen Effekt, dass eine elektromagnetische Welle, die in den metallischen Rahmen 3 eingekoppelt, von einer Reflektion auch gleich wieder ausgelöscht wird. Oder, anders erläutert, bewirkt die Platzierung der zumindest einen Kurzschluss-Durchkontaktierung 9 eine Halbierung bzw. Verkürzung der wirksamen Rahmenlänge mit sich, so dass die Eigenfrequenzen sich verdoppeln bzw. erhöhen. Es wird somit eine optimale Reduktion von Signalbeeinträchtigungen erzielt, so dass ein Hochfrequenzsignal möglichst ungestört von der Eingangssignalleitung bis zur Ausgangssignalleitung übermittelt werden kann.

Die Figuren 2 - 5 zeigen nun verschiedene Ansichten einer Ausführungsform, die sechs Kurzschluss-Kontaktierungen 9a-f aufweist. Die weiteren Komponenten des Bauelementes 1 sind vergleichbar zu der in der Figur 1b gezeigten Ausführung. Weiterhin ist zu bemerken, dass die bevorzugte Ausführungsform Koplanarleitungen für die Eingangs- und Ausgangssignalleitungen 5, 6 vorsieht und eine Mikrostreifenleitung für die innere Signalleitung 8. Auch wenn die Figuren jeweils nur eine Eingangs- und Ausgangssignalleitung 5, 6 und eine innere Signalleitung 8 zeigen, so sei darauf hingewiesen, dass weitere Leitungen vorgesehen sein können. Auch können, ähnlich dem Beispiel der Figur 1a, mehrere Ausgangsleitungen 6 für eine Eingangssignalleitung 5 oder umgekehrt vorgesehen sein. Ferner können auch mehrere Eingangs- und Ausgangsleitungen vorgesehen sein.

Die Figuren 2 - 4 zeigen Draufsichten auf eine schematische Darstellung des Bauelementes 1 mit verschiedenen Blickwinkeln, bei dem jeweils auf jeder Seite der Eingangs- und Ausgangssignalleitung 5, 6 eine Kurzschluss-Durchkontaktierung 9a, 9b, 9d, 9e vorgesehen ist. Bevorzugte Positionen für die Anordnung der Kurzschluss-Durchkontaktierungen 9 können jeweils Ecken oder Seitenkantenmitten sein. Dies zeigt die Figur 2 besonders gut. So ist jeweils seitlich zu einer Eingangs- bzw. Ausgangssignalleitung 5, 6 in der entsprechenden Ecke des Bauelementes 4 eine Kurzschluss-Durchkontaktierung 9a, 9e vorgesehen. Außerdem ist mittig zu den kürzeren Seitenkanten des Bauelementes 1 und auf der anderen Seite der Eingangs- bzw. Ausgangssignalleitung 5, 6 jeweils eine weitere Kurzschluss-Durchkontaktierung 9b, 9d vorgesehen. Diese "Einrahmung" der Eingangs- bzw. Ausgangssignalleitung 5, 6 haben sich als besonders effektiv beim Unterdrücken von Beeinträchtigungen des Signals erwiesen und somit wird diese Anordnung besonders bevorzugt.

Allerdings hat sich bereits eine sehr gute Signaltransmission ohne größere Störungen eingestellt, wenn nur bereits eine der vier Kurzschluss-Durchkontaktierungen 9 verwendet wurde. Es sind somit auch Ausführungsformen denkbar, die z.B. nur eine Kurzschluss-Durchkontaktierung 9 aufweist oder zwei, drei und mehr.

Eine weitere noch stärkere Reduktion wurde durch die Hinzunahme zumindest einer der beiden weiteren Kurzschluss-Durchkontaktierungen 9c, 9f oder sogar beider erreicht. Diese sind jeweils mittig zu der längeren Seitenkante des Bauelementes 1 und abseits bzw. entfernt von den Eingangs- und Ausgangssignalleitungen angeordnet. Der technische Effekt der Hinzunahme weiterer Kurzschluss-Durchkontaktierungen 9 kann u.a. dadurch erklärt werden, dass die wirksame Länge des Rahmens 3 weiter reduziert wird, so dass die Eigenfrequenzen weiter erhöht werden.

Zudem zeigen die Figuren 2 - 4 auch eine weitere bevorzugte und technisch vorteilhafte Ausgestaltung gegenüber den bekannten Konfigurationen auf; und zwar sind die Signalleitungsdurchkontaktierungen 7 möglichst so platziert, dass die Wellenwiderstände der Eingangs- und Ausgangssignalleitungen 5, 6 und des Rahmens 3 nicht übereinstimmen, um ein Einkoppeln möglichst bereits zu unterbinden (wie bereits oben diskutiert wurde, wurde hier beispielhaft eine Positionierung gewählt, die die erste Oberschwingung addressiert).

Zudem zeigen die Figuren 2 - 4, dass die Kurzschluss-Durchkontaktierungen 9 mittels elektrischer Kontaktflächen 9aa-9fa mit dem metallischen Rahmen 3 elektrisch kontaktiert sind. Diese Kontaktierung, zusammen mit der Kontaktierung zwischen Gehäusebauteil 2a bzw. der Masse der Signalleitungen 5, 6, erzeugt einen elektrischen Kurzschluss, der den oben erläuterten positiven technischen Effekt mit sich bringt. In Figur 2 ist zudem auch eine Durchführung 10 in dem Gehäusebauteil 2a angedeutet, durch die die Signalleitungsdurchkontaktierung 7 verläuft.

Weiterhin zeigt die Figur 5 eine schematische und vereinfachte beispielhafte Schnittansicht des hier beschriebenen Bauelementes 1, wobei die Anordnung der Eingangs- und Ausgangssignalleitungen 5, 6 auf einer Oberfläche eines ersten Gehäusebauteiles 2a genauso wie die Anordnung der inneren Signalleitung 8 auf dem gleichen Gehäusebauteiles 2a ersichtlich wird. Die beiden Leitungen sind mittels der Signalleitungsdurchkontaktierungen 7 elektrisch verbunden. Die Schnittansicht zeigt eine vermeintliche Unterbrechung der elektrischen Verbindung zwischen der inneren Leitung 8 und dem MEMS 11. Dies ist jedoch lediglich ein zeichnerischer Effekt aufgrund der Auswahl der Schnittebene. Zwischen der inneren Leitung 8 und dem MEMS 11 besteht eine elektrische Verbindung (dies gilt im Übrigen auch für die Figuren 2-4, in den ebenfalls eine vermeintliche Unterbrechung erkennbar zu sein scheint). Der Hohlraum 4 wird dann durch ein Fixieren des zweiten Gehäusebauteils 2b auf dem ersten mittels des metallischen Rahmens 3 hergestellt. Die Kurzschluss-Durchkontaktierungen 9 gemäß den Ansichten der Figuren 2 - 4 sind in der Schnittansicht nicht sichtbar. Die elektrische Masse bzw. ein Teil davon, die mit zumindest einer Kurzschluss-Durchkontaktierung 9 verbunden ist, ist in der Schnittansicht der Figur 5 als dicker Strick zwischen der Eingangssignalleitung 5 und der Ausgangssignalleitung 6 auf der Oberfläche des Gehäusebauteils 2a dargestellt und mit dem Referenzzeichen 13 gekennzeichnet.

Zusätzlich zu den Kurzschluss-Durchkontaktierungen 9 gemäß der Darstellung in den Figuren 2 - 4 können im Übrigen auch Teile (oder die gesamte Fläche) der Seitenwände (z.B. eine Außenseitenwand) des hier ersten Gehäusebauteils 2a metallisiert sein; und zwar derart, dass der elektrische Kurzschluss zwischen dem elektrischen Rahmen 3 und der Masse der Eingangs- und/oder Ausgangssignalleitungen 5, 6 hergestellt ist.

Eingesetzt wird in den Hohlraum 4 bevorzugt zumindest ein Kleinstapparat, z.B. in Form eines MEMS oder dgl. Besonders bevorzugt wird beispielsweise die Unterbringung eines MEMS-Schalters, der innerhalb einer Hochfrequenzleitung eingesetzt werden soll. Der Kleinstapparat ist aufgrund der hermetischen Kapselung zwischen den beiden fest miteinander verbauten Gehäusebauteilen 2a, 2b sicher gegenüber äußeren Einflüssen, wie Feuchtigkeit oder Verunreinigungen, gelagert.

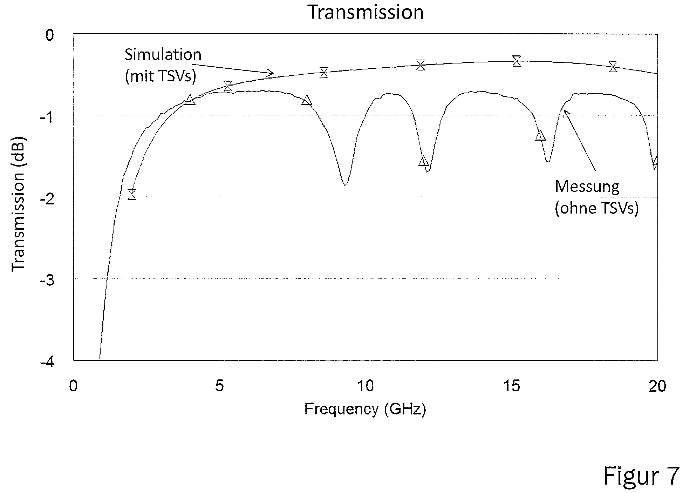

Wie bereits für die Figur 6 erläutert wurde, zeigt die Figur 7 eine Transmission für eine Simulation des hier beschriebenen Bauelementes 1 mit Kurzschluss-Durchkontaktierung 9 (Sanduhrmarkierungen) und zum Vergleich noch einmal die Messergebnisse (dreieckige Markierungen) aus Figur 6. Im Vergleich zu den Ergebnissen gemäß Figur 6 (bekannte Bauelemente) und dem Simulationsergebnis gemäß Figur 7 (hier beschriebenes Bauelement) kann eine deutliche Verbesserung beobachtet werden, wobei keine Signaleinbrüche erkennbar sind.

Abschließend kann somit zusammengefasst werden, dass hier ein elektronisches Hochfrequenz-Bauelement 1 beschrieben wird, das im Hinblick auf die Fähigkeit ein Hochfrequenzsignal möglichst ungestört zu übertragen gegenüber bekannten Bauelementen weiter verbessert wurde und das zudem mit wenig Aufwand fertigbar und auf einer Leiterplatte integrierbar ist.

## Patentansprüche

1. Elektronisches Hochfrequenz-Bauelement zur Aufnahme von Kleinstapparaten (11) mit:
zumindest zwei Gehäusebauteilen (2a, 2b) aus Silizium, Glas, Quarz oder einer Keramik, die mittels eines metallischen Rahmens (3) miteinander verbunden sind und einen Hohlraum (4) einschließen, und
zumindest einer Eingangssignalleitung (5) und einer Ausgangssignalleitung (6) zum Einleiten und Ausleiten von elektrischen Hochfrequenzsignalen in den Hohlraum (4) und aus dem Hohlraum (4), wozu die Eingangs- und die Ausgangssignalleitung (5, 6) jeweils mit einer Signalleitungsdurchkontaktierung (7) durch eines der Gehäuseteile (2a, 2b) verbunden ist, **dadurch gekennzeichnet, dass**
auf jeder Seite der Eingangs- und der Ausgangssignalleitung (5, 6) jeweils eine Kurzschluss-Durchkontaktierung (9) angeordnet ist, die den metallischen Rahmen (3) mit einer elektrischen Masse (13) an zumindest einem der Gehäusebauteile (2a, 2b) des Bauelementes (1) elektrisch verbindet, wobei die elektrische Masse (13) auf einer Oberfläche des Gehäusebauteils (2a; 2b) oder in dieses integriert ausgeformt ist.

2. Elektronisches Hochfrequenz-Bauelement gemäß Anspruch 1, wobei die zumindest zwei Signalleitungsdurchkontaktierungen (7) beabstandet zueinander angeordnet sind und mittels zumindest einer inneren Signalleitung (8) miteinander verbunden sind.

3. Elektronisches Hochfrequenz-Bauelement gemäß einem der voranstehenden Ansprüche, wobei die Kurzschluss-Durchkontaktierung (9) mittels einer metallisierten Seitenwand von zumindest einem der beiden Gehäusebauteile (2a, 2b) ausgeführt ist.

4. Elektronisches Hochfrequenz-Bauelement gemäß einem der voranstehenden Ansprüche, wobei die Eingangs- und Ausgangssignalleitungen (5, 6) Koplanarleitungen sind.

5. Elektronisches Hochfrequenz-Bauelement gemäß Anspruch 4, wobei die Kurzschluss-Durchkontaktierung (9) eine elektrische Masse einer Koplanarleitung mit dem metallischen Rahmen (3) elektrisch verbindet.

6. Elektronisches Hochfrequenz-Bauelement gemäß einem der voranstehenden Ansprüche, wobei die Kurzschluss-Durchkontaktierung (9) an einer Seitenkantenmitte und/oder Seitenkantenecke des metallischen Rahmens (3) angeordnet ist.

7. Elektronisches Hochfrequenz-Bauelement gemäß einem der voranstehenden Ansprüche, wobei die Durchkontaktierungen (7, 9) vertikal zum Hohlraum (4) angeordnet sind.

8. Elektronisches Hochfrequenz-Bauelement gemäß einem der voranstehenden Ansprüche, wobei eine Durchführung (10), in der die Signalleitungsdurchkontaktierung (7) angeordnet ist, innerhalb des metallischen Rahmens (3) angeordnet ist und dort an einer Stelle, an der ein maximaler Unterschied zwischen dem Wellenwiderstand der Eingangs- oder Ausgangssignalleitung (5, 6) und dem des metallischen Rahmens (3) vorliegt.

9. Elektronisches Hochfrequenz-Bauelement gemäß einem der voranstehenden Ansprüche, wobei das Bauelement (1) bzw. die Gehäusebauteile (2a, 2b) eine rechteckige oder quadratische Form aufweisen.

10. Elektronisches Hochfrequenz-Bauelement gemäß einem der voranstehenden Ansprüche, wobei die Signalleitungsdurchkontaktierungen (7) elektrisch miteinander verbundener Eingangs- und Ausgangssignalleitungen (5, 6) gegenüber liegend angeordnet sind.

11. Elektronisches Hochfrequenz-Bauelement gemäß einem der voranstehenden Ansprüche, wenn auf Anspruch 2 rückbezogen, wobei die innere Signalleitung (8) eine Mikrostreifenleitung ist, die einen Kleinstapparat (11) elektrisch mit der Eingangs- und Ausgangssignalleitung (5, 6) verbinden kann.

12. Elektronisches Hochfrequenz-Bauelement gemäß einem der voranstehenden Ansprüche, wenn auf Anspruch 2 rückbezogen, wobei die Eingangs- und Ausgangssignalleitungen (5, 6) und die innere Signalleitung (8) auf dem gleichen Gehäusebauteil (2a, 2b) angeordnet sind.

13. Elektronisches Hochfrequenz-Bauelement gemäß einem der voranstehenden Ansprüche, wenn auf Anspruch 2 rückbezogen, wobei die Signalleitungsdurchkontaktierungen (7) die innere Signalleitung (8) jeweils mit der Eingangs- und Ausgangssignalleitung (5, 6) elektrisch verbinden.

14. Elektronisches Hochfrequenz-Bauelement gemäß einem der voranstehenden Ansprüche, wobei der zumindest eine Kleinstapparat (11) ein mikroelektromechanisches System ist.

## Claims

1. Electronic radio-frequency component for holding miniature devices (11), having:
at least two housing subassemblies (2a, 2b) made of silicon, glass, quartz or a ceramic, which are connected to one another by means of a metal frame (3) and enclose a cavity (4), and
at least an input signal line (5) and an output signal line (6) for routing electrical radio-frequency signals into the cavity (4) and out of the cavity (4), to which end the input signal line and the output signal line (5, 6) are each connected to a signal line plated-through hole (7) by one of the housing parts (2a, 2b), **characterized in that**
a respective short-circuit plated-through hole (9) is arranged on each side of the input signal line and the output signal line (5, 6), which short-circuit plated-through hole electrically connects the metal frame (3) to an electrical earth (13) on at least one of the housing subassemblies (2a, 2b) of the component (1), wherein the electrical earth (13) is formed on a surface of the housing subassembly (2a; 2b) or in a manner integrated therein.

2. Electronic radio-frequency component according to Claim 1, wherein the at least two signal line plated-through holes (7) are arranged at an interval from one another and are connected to one another by means of at least one internal signal line (8).

3. Electronic radio-frequency component according to either of the preceding claims, wherein the short-circuit plated-through hole (9) is embodied by means of a metallized side wall of at least one of the two housing subassemblies (2a, 2b).

4. Electronic radio-frequency component according to one of the preceding claims, wherein the input and output signal lines (5, 6) are coplanar lines.

5. Electronic radio-frequency component according to Claim 4, wherein the short-circuit plated-through hole (9) electrically connects an electrical earth of a coplanar line to the metal frame (3).

6. Electronic radio-frequency component according to one of the preceding claims, wherein the short-circuit plated-through hole (9) is arranged at a lateral edge centre and/or lateral edge corner of the metal frame (3) .

7. Electronic radio-frequency component according to one of the preceding claims, wherein the plated-through holes (7, 9) are arranged vertically in relation to the cavity (4).

8. Electronic radio-frequency component according to one of the preceding claims, wherein a bushing (10), in which the signal line plated-through hole (7) is arranged, is arranged inside the metal frame (3) and, there, at a point at which there is a maximum difference between the characteristic impedance of the input or output signal line (5, 6) and that of the metal frame (3).

9. Electronic radio-frequency component according to one of the preceding claims, wherein the component (1) and the housing subassemblies (2a, 2b) have a rectangular or square shape.

10. Electronic radio-frequency component according to one of the preceding claims, wherein the signal line plated-through holes (7) of electrically interconnected input and output signal lines (5, 6) are arranged opposite.

11. Electronic radio-frequency component according to one of the preceding claims, when referring back to Claim 2, wherein the internal signal line (8) is a microstrip line that can electrically connect a miniature device (11) to the input and output signal line (5, 6).

12. Electronic radio-frequency component according to one of the preceding claims, when referring back to Claim 2, wherein the input and output signal lines (5, 6) and the internal signal line (8) are arranged on the same housing subassembly (2a, 2b).

13. Electronic radio-frequency component according to one of the preceding claims, when referring back to Claim 2, wherein the signal line plated-through holes (7) electrically connect the internal signal line (8) in each case to the input and output signal line (5, 6) .

14. Electronic radio-frequency component according to one of the preceding claims, wherein the at least one miniature device (11) is a microelectromechanical system.

## Revendications

1. Composant électronique haute fréquence destiné à recevoir de petits appareils (11), comportant : au moins deux éléments de boîtier (2a, 2b) en silicium, en verre, en quartz ou en céramique, qui sont reliés les uns aux autres au moyen d'un châssis métallique (3) et entourent une cavité (4), et
au moins une ligne de signaux d'entrée (5) et une ligne de signaux de sortie (6) pour l'injection et l'extraction de signaux électriques haute fréquence dans la cavité (4) et hors de la cavité (4), les lignes de signaux d'entrée et de sortie (5, 6) étant à cet effet respectivement reliées à une métallisation traversante de ligne de signal (7) par l'une des partis de boîtier (2a, 2b),
**caractérisé en ce que**, de chaque côté des lignes de signaux d'entrée et de sortie (5, 6), est respectivement disposée une métallisation traversante de court-circuit (9) qui relie électriquement le châssis métallique (3) à une masse électrique (13) sur au moins l'un des éléments de boîtier (2a, 2b) du composant (1), dans lequel la masse électrique (13) est formée sur une surface de l'élément de boîtier (2a ; 2b) ou y est intégrée.

2. Composant électronique haute fréquence selon la revendication 1, dans lequel lesdites au moins deux métallisations traversantes de lignes de signaux (7) sont disposées à distance les unes des autres et sont reliées les unes aux autres au moyen d'au moins une ligne de signal interne (8).

3. Composant électronique haute fréquence selon l'une des revendications précédentes, dans lequel la métallisation traversante de court-circuit (9) est réalisée au moyen d'une paroi latérale métallisée d'au moins l'un des deux éléments de boîtier (2a, 2b).

4. Composant électronique haute fréquence selon l'une des revendications précédentes, dans lequel les lignes de signaux d'entrée et de sortie (5, 6) sont des lignes coplanaires.

5. Composant électronique haute fréquence selon la revendication 4, dans lequel la métallisation traversante de court-circuit (9) relie électriquement une masse électrique d'un conducteur coplanaire au châssis métallique (3).

6. Composant électronique haute fréquence selon l'une des revendications précédentes, dans lequel la métallisation traversante de court-circuit (9) est disposée au niveau d'un bord latéral central et/ou d'un angle de bord latéral du châssis métallique (3).

7. Composant électronique haute fréquence selon l'une des revendications précédentes, dans lequel les métallisations traversantes (7, 9) sont disposées verticalement par rapport à la cavité (4).

8. Composant électronique haute fréquence selon l'une des revendications précédentes, dans lequel il est prévu un passage traversant (10) dans lequel est disposée la métallisation traversante de ligne de signal (7), à l'intérieur du châssis métallique (3) à un emplacement où il existe une différence maximale entre l'impédance caractéristique de la ligne de signal d'entrée ou de sortie (5, 6) et celle du châssis métallique (3).

9. Composant électronique haute fréquence selon l'une des revendications précédentes, dans lequel le composant (1) ou les éléments de boîtier (2a, 2b) présentent une forme rectangulaire ou carrée.

10. Composant électronique haute fréquence selon l'une des revendications précédentes, dans lequel des lignes de signaux d'entrée et de sortie (5, 6) reliant électriquement entre elles les métallisations traversantes de lignes de signaux (7) sont disposées en vis-à-vis.

11. Composant électronique haute fréquence selon l'une des revendications précédentes lorsqu'elles font référence à la revendication 2, dans lequel la ligne de signal interne (8) est une ligne à microruban qui peut relier électriquement un petit appareil (11) à la ligne de signal d'entrée et de sortie (5, 6).

12. Composant électronique haute fréquence selon l'une des revendications précédentes lorsqu'elles font référence à la revendication 2, dans lequel les lignes de signaux d'entrée et de sortie (5, 6) et la ligne de signaux interne (8) sont disposées sur le même élément de boîtier (2a, 2b).

13. Composant électronique haute fréquence selon l'une des revendications précédentes lorsqu'elles font référence à la revendication 2, dans lequel les métallisations traversantes de lignes de signaux (7) relient respectivement électriquement la ligne de signal interne (8) à la ligne de signal d'entrée et de sortie (5, 6).

14. Composant électronique haute fréquence selon l'une des revendications précédentes, dans lequel ledit au moins un petit appareil (11) est un système microélectromécanique.
